(19) **Europäisches Patentamt / European Patent Office / Office européen des brevets**

(11) **EP 3 916 774 A1**

(12) # EUROPEAN PATENT APPLICATION
published in accordance with Art. 153(4) EPC

(43) Date of publication:
01.12.2021 Bulletin 2021/48

(21) Application number: 20744741.8

(22) Date of filing: 21.01.2020

(51) Int Cl.:
$H01L\ 23/36$ (2006.01)   $C08L\ 21/00$ (2006.01)
$C08J\ 5/18$ (2006.01)   $C08K\ 3/38$ (2006.01)
$C08J\ 7/00$ (2006.01)

(86) International application number:
PCT/JP2020/001992

(87) International publication number:
WO 2020/153377 (30.07.2020 Gazette 2020/31)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 22.01.2019 JP 2019008849
22.01.2019 JP 2019008850
22.01.2019 JP 2019008851

(71) Applicant: SEKISUI CHEMICAL CO., LTD.
Osaka-shi
Osaka
530-8565 (JP)

(72) Inventor: HOSHIYAMA, Yuuki
Hasuda-shi, Saitama 349-0198 (JP)

(74) Representative: Ter Meer Steinmeister & Partner
Patentanwälte mbB
Nymphenburger Straße 4
80335 München (DE)

(54) **THERMALLY-CONDUCTIVE RESIN SHEET**

(57) The thermally conductive resin sheet of the present invention has a heat conductivity of 7 W/m·K or more, a 30% compressive strength of 1500 kPa or less, and a rate of change of the 30% compressive strength of 30% or less after a heat resistance test in which the thermally conductive resin sheet is heated for 1000 hours at 150°C. According to the present invention, a thermally conductive resin sheet with good heat conductive property and flexibility and long-term stability of physical properties such as not becoming hardened over time can be provided.

Fig. 1

**Description**

Technical Field

The present invention relates to a thermally conductive resin sheet.

Background Art

A thermally conductive resin sheet is primarily disposed between a heating element such as a semiconductor package and a heat sink such as aluminum or copper and has a function to quickly move the heat generated at the heating element to the heat sink. In recent years, higher integration of semiconductor elements and high-density wiring on a semiconductor package have been increasing an amount of heat generation per unit area of a semiconductor package and, as a result, a demand has been increasing for thermally conductive resin sheets with a more improved heat conductivity and a capability of facilitating quicker heat dissipation when compared with the conventional thermal-conducting sheets.

A thermally conductive resin sheet comprising a thermally conductive filler is known as such a thermally conductive resin sheet. For example, PTL1 describes an invention regarding a thermally conductive resin sheet comprising a liquid polybutene and a thermally conductive filler, and PTL2 describes an invention regarding a thermally conductive resin sheet comprising an epoxy resin and hexagonal boron nitride as a thermally conductive filler.

Citation List

Patent Literature

    PTL1: JP 2012-38763 A
    PTL2: JP 2013-254880 A

Summary of Invention

Technical Problem

There is a concern that when a thermally conductive resin sheet in general has an increased content of a thermally conductive filler to improve a heat conductivity, the sheet hardens and causes solder cracks, warping of a substrate and the like in an electronic device in which the sheet is used, thus damaging the electronic components. That is, it is difficult to increase a heat conductivity of a thermally conductive resin sheet while maintaining satisfactory flexibility, and hence techniques that make them compatible are in demand.

In recent years, attention has been paid as a problem to a long-term use of a thermally conductive resin sheet which causes changes of physical properties of the sheet over time such as making it hard and damaging electronic components, and accordingly the maintenance of long-term stability of physical properties is demanded.

Additionally, in recent years, a problem has been posed to a long-term use of a thermally conductive resin sheet which causes the generation of an outgas from the thermally conductive resin sheet, and the outgas clouds optical components such as camera lens thereby causing malfunctions of an electronic device. Further, low-molecular siloxane in the outgas which causes a contact fault is also problematic.

The present invention is made in view of the above conventional problems, and an object of the present invention is to provide a thermally conductive resin sheet with good heat conductive property and flexibility and long-term stability of physical properties such as not becoming hardened over time. Additionally, another object of the present invention is to provide a thermally conductive resin sheet with good heat conductive property and flexibility and reduced outgas generation.

Solution to Problem

The present inventors conducted extensive studies to achieve the goals and consequently found that the above object is solved by a thermally conductive resin sheet having a heat conductivity of 7 W/m·K or more, a 30% compressive strength of 1500 kPa or less, and a rate of change of the 30% compressive strength of 30% or less after a heat resistance test in which the thermally conductive resin sheet is heated for 1000 hours at 150°C, whereby the present invention was accomplished.

Further, the present inventors found that the above another object is solved by a thermally conductive resin sheet having a heat conductivity of 7 W/m·K or more, a 30% compressive strength of 1500 kPa or less, the total amount of an outgas of 500 ppm or less, and the total siloxane amount of 20 ppm or less contained in the outgas, whereby the present invention has been accomplished.

That is, the present invention relates to the following [1] to [13].

[1] A thermally conductive resin sheet having a heat conductivity of 7 W/m·K or more, a 30% compressive strength of 1500 kPa or less, and a rate of change of the 30% compressive strength of 30% or less after a heat resistance test in which the thermally conductive resin sheet is heated for 1000 hours at 150°C.

[2] A thermally conductive resin sheet having a heat conductivity of 7 W/m·K or more, a 30% compressive strength of 1500 kPa or less, a total amount of an outgas of 500 ppm or less, and a total siloxane amount of 20 ppm or less contained in the outgas.

[3] The thermally conductive resin sheet according to the above [1] or [2], wherein a tensile strength is 0.08 MPa or more, and a rate of change of the tensile strength after the heat resistance test is 0 to 30%.

[4] The thermally conductive resin sheet according to any of the above [1] to [3], wherein a surface tensile strength when the thermally conductive resin sheet is 30% compressed, cured for 24 hours at 23°C in the compressed state and subsequently measured for the surface tensile strength is 0.10 N/mm$^2$ or more, or an elongation at the surface tensile strength measurement is 0.20 mm or more.

[5] The thermally conductive resin sheet according to any of the above [1] to [4], comprising an elastomer resin.

[6] The thermally conductive resin sheet according to the above [5], wherein the elastomer resin comprises a liquid elastomer resin.

[7] The thermally conductive resin sheet according to the above [6], wherein a viscosity of the liquid elastomer resin at 25°C is 1 to 150 Pa·s.

[8] The thermally conductive resin sheet according to any of the above [1] to [7], comprising a thermally conductive filler.

[9] The thermally conductive resin sheet according to the above [8], wherein the thermally conductive filler comprises a non-spherical filler.

[10] The thermally conductive resin sheet according to the above [8] or [9], wherein a major axis of the thermally conductive filler is oriented at an angle of 60° or more to a sheet surface.

[11] The thermally conductive resin sheet according to any of the above [1] to [10], which is crosslinked.

[12] The thermally conductive resin sheet according to any of the above [1] to [11], wherein an oil bleed distance is 10 mm or less.

[13] The thermally conductive resin sheet according to any of the above [1] to [12], wherein a gel fraction at at least one of surface layer parts is higher than a gel fraction at a center part.

Advantageous Effects of Invention

According to the present invention, a thermally conductive resin sheet with good heat conductive property and flexibility and long-term stability of physical properties such as not becoming hardened over time can be provided. Further, according to the present invention, a thermally conductive resin sheet with good heat conductive property and flexibility and reduced outgas generation can be provided.

Brief Description of Drawings

[Fig. 1] Fig. 1 is a schematic cross-sectional view of a thermally conductive resin sheet consisting of a laminated body.
[Fig. 2] Fig. 2 is a schematic cross-sectional view of a thermally conductive resin sheet consisting of a laminated body in operation.
[Fig. 3] Fig. 3 is a schematic view describing a method for measuring a surface tensile strength and an elongation.
[Fig. 4] Fig. 4 is a schematic view describing a method for measuring a surface tensile strength and an elongation.

Description of Embodiments

[Thermally conductive resin sheet]

The thermally conductive resin sheet of the present invention has a heat conductivity of 7 W/m·K or more, a 30% compressive strength of 1500 kPa or less, and a rate of change of the 30% compressive strength of 30% or less after a heat resistance test in which the thermally conductive resin sheet is heated for 1000 hours at 150°C.

In general, a thermally conductive resin sheet tends to reduce flexibility as a heat conductivity increases but the thermally conductive resin sheet of the present invention has a 30% compressive strength of 1500 kPa or less and good flexibility as well despite a high heat conductivity of 7W/m·K or higher.

Further, the thermally conductive resin sheet of the present invention has a rate of change of the 30% compressive strength of 30% or less after a heat resistance test, thereby having good long-term stability of physical properties.

(Heat conductivity)

A heat conductivity of the thermally conductive resin sheet of the present invention is 7 W/m·K or more. A heat conductivity of less than 7 W/m·K fails to sufficiently dissipate the heat generated from a heating element. A heat conductivity of the thermally conductive resin sheet is, from a viewpoint of improving the heat dissipation property of the thermally conductive resin sheet, preferably 8 W/m·K or more, and more preferably 10 W/m·K or more. Additionally, the higher a heat conductivity of the thermally conductive resin sheet, the better, but is typically 100 W/m·K or less. A heat conductivity is more likely to be adjusted to the desired value by, for example, adjusting the content and the orientation of thermally conductive fillers to be described later.

(30% Compressive strength)

The 30% compressive strength of thermally conductive resin sheet of the present inventio is 1500 kPa or less. A 30% compressive strength of more than 1500 kPa reduces the flexibility of the sheet and is more likely to damage electronic components in an electronic device in which such a sheet is used. A 30% compressive strength of the thermally conductive resin sheet is, from a viewpoint of increasing the flexibility of the thermally conductive resin sheet, preferably 1000 kPa or less, and more preferably 800 kPa or less. Additionally, a 30% compressive strength of the thermally conductive resin sheet is typically 50 kPa or more, and preferably 200 kPa or more.

The 30% compressive strength of the thermally conductive resin sheet can be adjusted by the kind of resin composing the thermally conductive resin sheet, the presence or absence of crosslinking, the amount of thermally conductive fillers and the like to be described later.

The 30% compressive strength means the load obtained when the resin sheet is compressed to a thickness equivalent to 30% of the original thickness and can be determined by the method described in an example.

The thermally conductive resin sheet of the present invention has a rate of change of the 30% compressive strength of 30% or less after a heat resistance test. A rate of change of the 30% compressive strength after a heat resistance test of more than 30% hardens the thermally conductive resin sheet after a long-term use and is thereby likely to damage electronic components in an electronic device in which such a sheet is used. A rate of change of the 30% compressive strength after a heat resistance test of the thermally conductive resin sheet is, from a viewpoint of maintaining a suitable flexibility of the thermally conductive resin sheet and long-term stable use, preferably 0 to 20%, more preferably 0 to 15%, and further preferably 0 to 10%.

The rate of change of the 30% compressive strength after a heat resistance test can be adjusted by the kind of resin used, the gel fraction, the amount of thermally conductive fillers and the like. In particular, it is preferable that a crosslinked thermally conductive resin sheet having a certain value or higher of a gel fraction be used to lower the rate of change of the 30% compressive strength after a heat resistance test. This is considered because crosslinking reduces active spots in a resin reactable by heat or reduces bleeding substances caused by heat, whereby structural changes of the thermally conductive resin sheet caused by heat are less likely to occur.

In the present description, the heat resistance test means the test in which a sample is heated for 1000 hours at 150°C. Additionally, the rate of change (%) of the 30% compressive strength after the heat resistance test can be determined by the following formula (1).

$$ \mid (1 - 30\% \text{ Compressive strength before heat resistance test} / 30\% \text{ compressive strength after heat resistance test}) \times 100 \mid \qquad \text{Formula (1)} $$

Formula (1) indicates the absolute value of (1 - 30% compressive strength before heat resistance test / 30% compressive strength after heat resistance test) x 100.

The present invention can also provide a thermally conductive resin sheet having a heat conductivity of 7 W/m·K or more, a 30% compressive strength of 1500 kPa or less, the total amount of an outgas of 500 ppm or less, and the total siloxane amount of 20 ppm or less contained in the outgas.

In general, the thermally conductive resin sheet tends to reduce flexibility as a heat conductivity increases but the thermally conductive resin sheet of the present invention has a 30% compressive strength of 1500 kPa or less and good flexibility as well despite a high heat conductivity of 7 W/m·K or higher.

Further, the thermally conductive resin sheet of the present invention having the total amount of outgas of 500 ppm or less is thus a thermally conductive resin sheet which hardly generates an outgas. Thus, in addition to the hardly generated outgas, the total siloxane amount contained in the outgas is 20 ppm or less, thus least likely causing a contact failure.

(Total amount of outgas)

The total amount of outgas of the thermally conductive resin sheet of the present invention is 500 ppm or less. A total amount of outgas of more than 500 ppm may cause a failure in an electronic device such as clouded optical components causing malfunctions. Considering such a viewpoint, the total amount of outgas in the thermally conductive resin sheet is preferably 400 ppm or less, and more preferably 300 ppm or less.

The total amount of outgas of the thermally conductive resin sheet can be adjusted by the composition of the thermally conductive resin sheet, the presence or absence of crosslinking and the like, but from a viewpoint of reducing the total amount of outgas, it is particularly effective to make a gel fraction at at least one of the surface layer parts of the thermally conductive resin sheet higher than a gel fraction at the center part or to adjust a gel fraction ratio in the thickness direction. The gel fraction at the surface layer part, the gel fraction at the center part, and the gel fraction ratio in the thickness direction will be described later in detail.

The total amount of outgas of the thermally conductive resin sheet can be measured by gas chromatography-mass spectrometry (GC-MS method).

(Total amount of siloxane in outgas)

The total amount of siloxane contained in an outgas of the thermally conductive resin sheet of the present invention is 20 ppm or less. A total amount of siloxane of higher than 20 ppm may cause a contact fault when the thermally conductive resin sheet is used for heat dissipation in an electronic device. The above total amount of siloxane means the total siloxane amount in the thermally conductive resin sheet.

Considering such a viewpoint, the total amount of siloxane in outgas of the thermally conductive resin sheet is preferably 15 ppm or less, more preferably 10 ppm or less, further preferably 5 ppm or less, and particularly preferably 0 ppm.

The total amount of siloxane can be adjusted by using a certain content or less of a silicone-based resin in the thermally conductive resin sheet. The content of a silicone-based resin in the thermally conductive resin sheet will be described later in detail.

Additionally, it is preferable that the thermally conductive resin sheet of the present invention have a heat conductivity of 7 W/m·K or more, a 30% compressive strength of 1500 kPa or less as described above, and that the rate of change of the 30% compressive strength after the heat resistance test, the total amount of outgas, and the total amount of siloxane in the outgas be adjusted to the above ranges. This enables to provide the thermally conductive resin sheet with good heat conductive property, flexibility and long-term stability of physical properties and further reduced outgas generation.

(Surface tensile strength)

The thermally conductive resin sheet of the present invention, when 30% compressed, cured for 24 hours at 23°C in the compressed state and subsequently measured for a surface tensile strength, preferably has a surface tensile strength of 0.10 N/mm$^2$ or more, or has an elongation at the surface tensile strength measurement of 0.20 mm or more.

When the thermally conductive resin sheet of the present invention satisfies either a surface tensile strength of 0.10 N/mm$^2$ or more or an elongation of 0.20 mm or more, the adhesiveness becomes satisfactory when the thermally conductive resin sheet is disposed on adherends (between heating elements and heat sinks and the like) in an electronic device, and thus the thermally conductive resin sheet can be prevented from being peeled off by differences in coefficients of linear expansion of the adherends. For this reason, the thermally conductive resin sheet can be used stably for a long time.

The thermally conductive resin sheet preferably has a surface tensile strength of 0.10 N/mm$^2$ or more and an elongation of 0.20 mm or more at the surface tensile strength measurement from a viewpoint of improving the adhesiveness of the thermally conductive resin sheet and successfully preventing the peeling off.

A surface tensile strength of the thermally conductive resin sheet of the present invention is more preferably 0.11 N/mm$^2$ or more, and further preferably 0.13 N/mm$^2$ or more. The surface tensile strength is typically 1.00 N/mm$^2$ or less.

An elongation at the surface tensile strength measurement of the thermally conductive resin sheet of the present invention is more preferably 0.23 mm or more, and further preferably 0.30 mm or more. The elongation is typically 2 mm or less.

The surface tensile strength and the elongation of the thermally conductive resin sheet can be adjusted by the kind of resin composing the thermally conductive resin sheet, the gel fraction, the amount of thermally conductive fillers and the like to be described later.

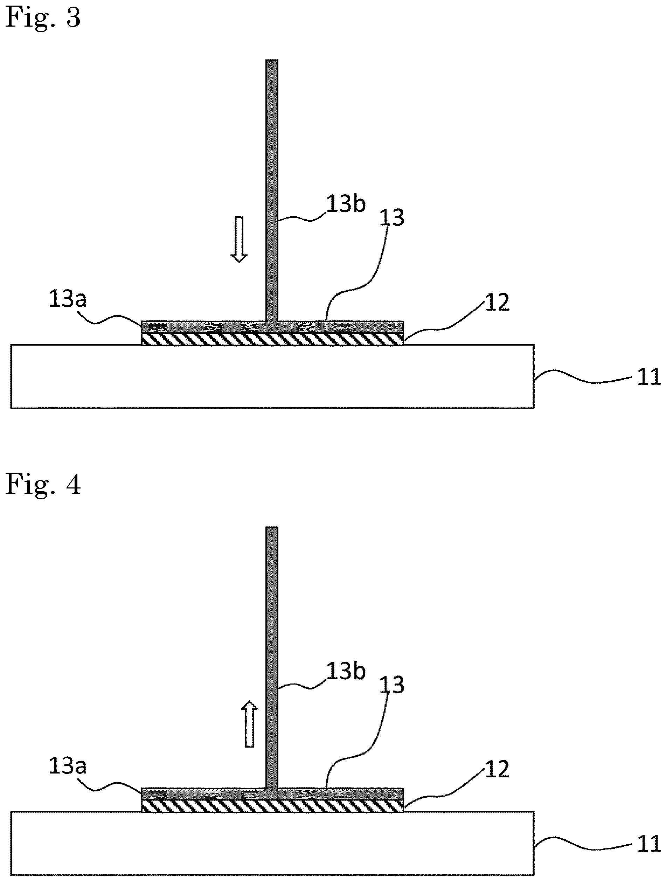

The method of surface tensile strength measurement is described in reference to Fig. 3 and Fig. 4.

(1) A polycarbonate plate 11 having a thickness of 10 mm and a size of 50 mm x 50 mm, a thermally conductive resin sheet 12 having a thickness of 2 mm and a size of 25 mm x 25 mm, and a T-shaped aluminum jig (A5052) 13 consisting of a flat plate part 13a (size 25 mm x 25 mm) and a stick-like member 13b (length 25 mm) fixed vertically from the center part of the flat plate part 13a are prepared.

(2) As shown in Fig. 3, the thermally conductive resin sheet 12 is interposed between the polycarbonate plate 11 and the flat plate part 13a of the T-shaped aluminum jig 13, and a load is applied to 30% compress the thickness of the thermally conductive resin sheet 12 and thereby to adhere the sheet thereto. The thickness of the thermally conductive resin sheet 12 at the compression is 1.4 mm.

(3) The sheet is cured for 24 hours at 23°C in the state of the above (2) followed by releasing the load, and after the lapse of 60 minutes, the polycarbonate plate is fixed onto a tensile tester and, as shown in Fig. 4, the T-shaped aluminum jig 13 is pulled upward in a rate of 1.0 mm/min, during which the relation between a strain (a length elongated in the thickness direction: mm) and a stress ($N/mm^2$) of the thermally conductive resin sheet is measured.

In the present measurement, the maximum value of stress is defined as the "surface tensile strength" and the strain at the time of a stress of 0.01 $N/mm^2$ is defined as the "elongation".

(Tensile strength)

The tensile strength of the thermally conductive resin sheet of the present invention is preferably 0.08 MPa or more. A tensile strength of 0.08 MPa or more can secure mechanical strengths of the thermally conductive resin sheet and more likely prevents the sheet from being partially raptured when, for example, the thermally conductive resin sheet is peeled off from adherents such as heating elements, and can further impart satisfactory adhesiveness with heating elements and the like. A tensile strength of the thermally conductive resin sheet is preferably 0.1 MPa or more, more preferably 0.3 MPa or more, and further preferably 0.5 MPa or more. The tensile strength of the thermally conductive resin sheet can be adjusted by the kind of resin composing the thermally conductive resin sheet, the gel fraction, the amount of thermally conductive fillers and the like to be described later.

The thermally conductive resin sheet of the present invention preferably has a rate of change of the tensile strength after the heat resistance test ranging from 0 to 30%. When a rate of change of the tensile strength is within the above range, a tensile strength does not become too low even when the thermally conductive resin sheet is used for a long time, whereby the flexibility of the thermally conductive resin sheet is maintained and handleability during work is good due to satisfactory reworkability of the thermally conductive resin sheet. A rate of change of the tensile strength after the heat resistance test of the thermally conductive resin sheet is preferably 0 to 28%, and more preferably 0 to 20%. The rate of change of the tensile strength after the heat resistance test can be adjusted by the gel fraction of the thermally conductive resin sheet, the amount of thermally conductive fillers and the like.

The rate of change (%) of the tensile strength after the heat resistance test can be determined by the following formula (2).

$$| \ (1 - \text{Tensile strength before heat resistance test / tensile strength after heat resistance test}) \ \text{x} \ 100 \ | \quad \text{Formula (2)}$$

Formula (2) indicates the absolute value of (1 - tensile strength before heat resistance test / tensile strength after heat resistance test) x 100.

The tensile strength can be determined by the method described in an example.

(Asker C hardness)

Asker C hardness of the thermally conductive resin sheet of the present invention is, from a viewpoint of imparting satisfactory flexibility, preferably 70 or less, more preferably 60 or less, and further preferably 50 or less. The Asker C hardness adjusted as described above is less likely to damage electronic components in an electronic device in which the sheet is used. The Asker C hardness of the thermally conductive resin sheet can be adjusted by the kind of resin composing the thermally conductive resin sheet, the presence or absence of crosslinking, the gel fraction, the amount of thermally conductive fillers and the like to be described later.

The thermally conductive resin sheet of the present invention preferably has a rate of change of the Asker C hardness after the heat resistance test of 0 to 30%, more preferably 0 to 20%, and further preferably 0 to 10%. A rate of change of the Asker C hardness after the heat resistance test adjusted as described above prevents the thermally conductive resin sheet from hardening when used for a long time and is less likely to damage heating elements such as electronic components. The rate of change of the Asker C hardness after the heat resistance test can be adjusted by the presence or absence of crosslinking of the thermally conductive resin sheet, the gel fraction, the amount of thermally conductive fillers and the like.

The rate of change (%) of the Asker C hardness after the heat resistance test can be determined by the following formula (3).

$$| \ (1 \text{ - Asker C hardness before heat resistance test / Asker C hardness after} \\ \text{heat resistance test}) \text{ x } 100 \ | \text{ Formula (3)}$$

Formula (3) indicates the absolute value of (1 - Asker C hardness before heat resistance test / Asker C hardness after heat resistance test) x 100.

The Asker C hardness can be determined by the method described in an example.

(Resin)

The thermally conductive resin sheet of the present invention comprises a resin, and the kind of the resin is not particularly limited but, from a viewpoint of imparting satisfactory flexibility, an elastomer resin is preferable.

Examples of the kind of elastomer resin include acrylonitrile butadiene rubbers, ethylene-propylene-diene rubbers, ethylene-propylene rubbers, natural rubbers, polyisoprene rubbers, polybutadiene rubbers, hydrogenated polybutadiene rubbers, styrene-butadiene block copolymers, hydrogenated styrene-butadiene block copolymers, hydrogenated styrene-butadiene-styrene block copolymers, hydrogenated styrene-isoprene block copolymers, hydrogenated styrene-isoprene-styrene block copolymers, and acrylic rubbers (acrylic rubber means polymerization product of monomers containing acrylic acid ester and/or methacrylic acid ester).

The above elastomer resins may be solid elastomers at room temperature (23°C) and atmospheric pressure (1 atm) or may be liquid elastomers.

A content of the elastomer resin is, on a basis of the resin total amount in the thermally conductive resin sheet of the present invention, preferably 60 mass% or more, more preferably 80 mass% or more, and further preferably 100 mass%.

The elastomer resin in the thermally conductive resin sheet preferably comprises a liquid elastomer resin from a viewpoint of improving the flexibility of the thermally conductive resin sheet of the present invention. The liquid elastomer resin is not particularly limited and, for example, liquid elastomer resins from the above elastomer resins can be used, with liquid acrylonitrile butadiene rubbers, liquid ethylene-propylene-diene rubbers, liquid polyisoprene rubbers, and liquid polybutadiene rubbers being preferable.

The elastomer resin may be used singly, or a plurality of kinds may be used in combination.

A viscosity of the liquid elastomer resin at 25°C is preferably 1 to 150 Pa·s, and more preferably 10 to 100 Pa·s.When two or more kinds of liquid elastomer resins are used in mixture, the viscosity after mixed is preferably as described above. When a viscosity is within the above range, the oil bleed distance to be described later can be shortened and stains on electronic components are more likely to be prevented.

A content of the liquid elastomer to a basis of the total amount of elastomer resin is preferably 60 mass% or more, more preferably 90 mass% or more, and further preferably 100 mass%.

The thermally conductive resin sheet preferably has a certain value or less of a content of the silicone-based resins such as silicone and liquid silicone. Specifically, a content of the silicone-based resins is, on a basis of the resin total amount in the thermally conductive resin sheet, preferably 10 mass% or less, more preferably 5 mass% or less, and further preferably 0 mass%. This enables the reduction of a siloxane amount contained in an outgas.

(Thermally conductive filler)

The thermally conductive resin sheet of the present invention preferably comprises thermally conductive fillers.

The thermally conductive fillers are preferably dispersed in the resin in the thermally conductive resin sheet. The heat conductivity of the thermally conductive filler is not particularly limited and is preferably 12 W/m·K or more, more preferably 15 to 70 W/m·K, and further preferably 25 to 70 W/m·K.

Examples of the material for thermally conductive filler include carbides, nitrides, oxides, hydroxides, metals, and carbon-based materials.

Examples of the carbide include silicon carbides, boron carbides, aluminum carbides, titanium carbides, and tungsten carbides.

Examples of the nitride include silicon nitrides, boron nitrides, boron nitride nanotubes, aluminum nitrides, gallium nitrides, chromium nitrides, tungsten nitrides, magnesium nitrides, molybdenum nitrides, and lithium nitrides.

Examples of the oxide include iron oxides, silicon oxides (silica), aluminum oxides (alumina) (including hydrates of aluminum oxide (boehmite and the like)), magnesium oxides, titanium oxides, cerium oxides, and zirconium oxides. Additional examples of the oxide include transition metal oxides such as barium titanate and further doped metal ions such as indium tin oxide and antimony tin oxide.

Examples of the hydroxide include aluminum hydroxides, calcium hydroxides, and magnesium hydroxides.

Examples of the metal include copper, gold, nickel, tin, iron, and alloys thereof.

Examples of the carbon-based material include carbon black, graphite, diamond, graphene, fullerene, carbon nanotube, carbon nanofiber, nanohorn, carbon micro coil, and nanocoil.

Examples of the thermally conductive filler other than the above include talc, which is a silicate mineral.

These thermally conductive fillers can be used singly or two or more kinds can be used in combination. The thermally conductive filler is, from a viewpoint of heat conductive property, preferably at least one kind selected from the group consisting of aluminum oxides, magnesium oxides, boron nitrides, aluminum nitrides, graphene, boron nitride nanotubes, carbon nanotube and diamond. Additionally, the thermally conductive filler, when being the non-spherical filler to be described later, is preferably at least either boron nitrides or graphene, whereas aluminum oxides are preferable in the case of a spherical filler. For the purpose of use that further requires electrical insulation property, boron nitrides are more preferable.

An average particle size of the thermally conductive fillers is preferably 0.1 to 300 $\mu$m, more preferably 0.5 to 100 $\mu$m, and further preferably 5 to 50 $\mu$m. The average particle size can be determined by measuring a particle distribution using a laser diffraction particle size analyzer.

A content of the thermally conductive fillers in the thermally conductive resin sheet to 100 parts by mass of the resin is preferably 180 to 3000 parts by mass, more preferably 200 to 2500 parts by mass, and further preferably 250 to 1000 parts by mass.

It is preferable that the content of the thermally conductive fillers be adjusted in accordance with the shape of the filler.

The shape of a thermally conductive filler is not particularly limited and may be a spherical filler or a non-spherical filler, but a non-spherical filler is preferable.

It is preferable for the thermally conductive filler to comprise a non-spherical filler. A non-spherical filler, when used, is more likely to provide the thermally conductive resin sheet with a higher tensile strength than when a spherical filler is used. Additionally, a heat conductive property is easily improved with a comparatively smaller amount, thereby likely obtaining the thermally conductive resin sheet in which satisfactory flexibility and high heat conductive property are compatible.

The "spherical" herein means the shape having an aspect ratio of 1.0 to 2.0, and preferably 1.0 to 1.5, and does not necessarily mean perfectly spherical. The aspect ratio for a spherical filler means the ratio of the longest diameter/the shortest diameter. Additionally, the "non-spherical" means the shapes other than the above spherical shape, that is, the shapes having aspect ratios more than 2.

Examples of the non-spherical filler include plate-like fillers such as scale-like and thin fillers, needle-like fillers, fibrous fillers, dendrite fillers, and irregular-shape fillers. Of these, plate-like fillers are preferable from a viewpoint of imparting satisfactory heat conductive property to the thermally conductive resin sheet.

The aspect ratio of a thermally conductive filler is, from a viewpoint of improving the heat conductive property, preferably 5 or more, more preferably 10 or more, and further preferably 15 or more.

The thermally conductive resin sheet can have further improved heat conductive property in the thickness direction when thermally conductive fillers having a high aspect ratio are oriented at a high orientation angle as to be described later.

The aspect ratio of a non-spherical filler is the ratio of the maximum length to the minimum length (maximum length/minimum length) of the filler, and, when the shape is plate-like, for example, the aspect ratio is the ratio of the maximum length to the thickness of the filler (maximum length/ thickness). The aspect ratio can be determined in terms of an average value by observing adequate number (for example, 250 pieces) of thermally conductive fillers using a scanning electron microscope.

The minimum length (equivalent to the thickness in the case of a plate-like filler) of a thermally conductive filler is, from a viewpoint of improving the heat conductivity, preferably 0.05 to 500 μm, and more preferably 0.25 to 250 μm.

When the thermally conductive filler comprises non-spherical fillers, a content of the non-spherical fillers is, to 100 parts by mass of the resin, preferably 180 to 700 parts by mass, more preferably 200 to 600 parts by mass, and further preferably 300 to 500 parts by mass. A content of 180 parts by mass or more increases heat conductive property, thus more likely achieving the heat conductivity specified in the present invention. Additionally, a content of 700 parts by mass or less is likely to provide satisfactory flexibility.

A content of non-spherical fillers in the thermally conductive filler on a basis of the total amount of the thermally conductive fillers is preferably 60 mass% or more, more preferably 90 mass% or more, and further preferably 100 mass%.

(Other additives)

Additives generally used in thermally conductive resin sheets such as an antioxidant, a heat stabilizer, a coloring agent, a fire retardant, an antistatic agent, a filler other than the above thermally conductive fillers, and a decomposition temperature regulator may be mixed as needed in the thermally conductive resin sheet of the present invention.

(Orientation)

In the thermally conductive resin sheet, the major axis of a thermally conductive filler is preferably oriented at an angle more than 45° to the sheet surface, which is the surface of the thermally conductive resin sheet, and more preferably oriented at an angle of 50° or more, further preferably 60° or more, further preferably 70° or more, and further preferably 80° or more. The thermally conductive fillers, when oriented as such, improve the heat conductivity in the thickness direction of the thermally conductive resin sheet. The major axis of a thermally conductive filler has the same direction as the maximum length of the thermally conductive filler described above.

The above angle can be measured by observing the cross-section of the thickness direction of the thermally conductive resin sheet using a scanning electron microscope. For example, a thin slice of the center portion in the thickness direction of the thermally conductive resin sheet is first prepared. Subsequently, the thermally conductive fillers in the thin slice are observed using a scanning electron microscope (SEM) at 3000x magnification, and angles formed between the major axis of the observed fillers and the plane composing the sheet surface are measured and thereby determined. In the present description, the angles of 45° or more, 50° or more, 60°, 70° or more, and 80° or more mean an average value of the values measured as described above is these angles or more. For example, in the "oriented at an angle of 70° or more", the 70° is an average value, and the presence of thermally conductive fillers having orientation angles of less than 70° is not denied. When a formed angle is more than 90°, a supplementary angle thereof is used as the measured value.

(Gel fraction)

A gel fraction throughout the thermally conductive resin sheet is, from a viewpoint of imparting satisfactory flexibility, preferably 50 mass% or less, and more preferably 40 mass% or less, and is also preferably 5 mass% or more, and preferably 10 mass% or more, from a viewpoint of reducing the rate of change of the 30% compressive strength, the rate of change of the tensile strength, and the rate of change of the Asker C hardness after the heat resistance test.

Thus, a gel fraction of a certain value or more reduces changes of physical properties after the heat resistance test. This is presumed because, as to be described later, the thermally conductive resin sheet crosslinked to increase a gel fraction reduces active spots reactable by heat or reduces bleeding substances caused by heat.

Additionally, a gel fraction at at least one of the surface layer parts of the thermally conductive resin sheet is preferably higher than a gel fraction at the center part from a viewpoint of imparting satisfactory flexibility to the thermally conductive resin sheet, from a viewpoint of adjusting the rate of change of the tensile strength after the heat resistance test to the desired range, from a viewpoint of inhibiting an oil from bleeding out, and from a viewpoint of reducing the outgas generation. More preferably, the gel fractions at both surface layer parts are preferably higher than the gel fraction at the center part.

The gel fraction correlates with the crosslinking degree of a resin, and generally the greater the crosslinking degree, the higher the gel fraction. The method for making a gel fraction at the surface layer part higher than that at the center part is not particularly limited but when, for example, electron beam irradiation to be described later is performed, an accelerating voltage and an irradiation dose of the electron beam can be adjusted.

The surface layer part refers to the region of up to 25% from the surface (sheet surface) to the thickness of the thermally conductive resin sheet, and the center part means the regions other than the surface layer parts.

A gel fraction at the surface layer part of the thermally conductive resin sheet is preferably 15 to 50 mass%, more preferably 20 to 45 mass%, and further preferably 26 to 40 mass%.

For the gel fraction of the surface layer part, it is preferable that a gel fraction at at least one of the surface layer parts be as described above, and it is preferable that both gel fractions of both surface layer parts be as described above.

A gel fraction at the center part of the thermally conductive resin sheet is preferably 2 to 35 mass%, more preferably 3 to 30 mass%, and further preferably 3 to 25 mass%.

A gel fraction ratio in the thickness direction (gel fraction at the center part / gel fraction at the surface layer part) is preferably 0.10 to 0.90, and preferably 0.15 to 0.80. Additionally, both surface layer parts of the thermally conductive resin sheet preferably have a gel fraction ratio in the thickness direction as described above. A gel fraction ratio within such a range imparts satisfactory flexibility to the thermally conductive resin sheet and can effectively reduce the bleeding out of an oil and outgas generation.

(Oil bleed distance)

The thermally conductive resin sheet of the present invention preferably has an oil bleed distance of 10 mm or less. An oil bleed distance of 10 mm or less prevents electronic components and optical signal components from being stained when the thermally conductive resin sheet is in use, whereby a short circuit and the attenuation and scattering of optical signals are more likely to be reduced. An oil bleed distance is preferably 9 mm or less, and more preferably 8 mm or less.

The oil bleed distance is easily adjusted to a desired value by, as described above, making a gel fraction at at least one of the surface layer parts of the thermally conductive resin sheet higher than a gel fraction at the center part, adjusting a gel fraction ratio in the thickness direction as described above, or adjusting a viscosity of an elastomer resin.

An oil bleed distance is determined by placing a sample (thermally conductive resin sheet) on a size A4 paper and measuring distances of oil seeped from edges of the sample 336 hours later at 125°C. The seepage distance is calculated as an average value by measuring the maximum seepage distances from each of the sides of the sample.

(Dielectric characteristics)

A dielectric constant at a frequency of 1 MHz of the thermally conductive resin sheet of the present invention is preferably 5.0 or less. A dielectric constant of 5.0 or less can reduce a transmission loss and noise caused by the thermally conductive resin sheet. From such a viewpoint, a dielectric constant at a frequency of 1 MHz is more preferably 4.5 or less.

Additionally, from the same viewpoint, a dielectric tangent at a frequency of 1 MHz of the thermally conductive resin sheet of the present invention is preferably 0.01 or less, and more preferably 0.005 or less.

In the thermally conductive resin sheet of the present invention, the dielectric constant and dielectric tangent can be adjusted to the above ranges by using thermally conductive fillers having a low dielectric constant and a dielectric tangent such as boron nitrides and increasing a mixing amount of such thermally conductive fillers.

(Laminated body)

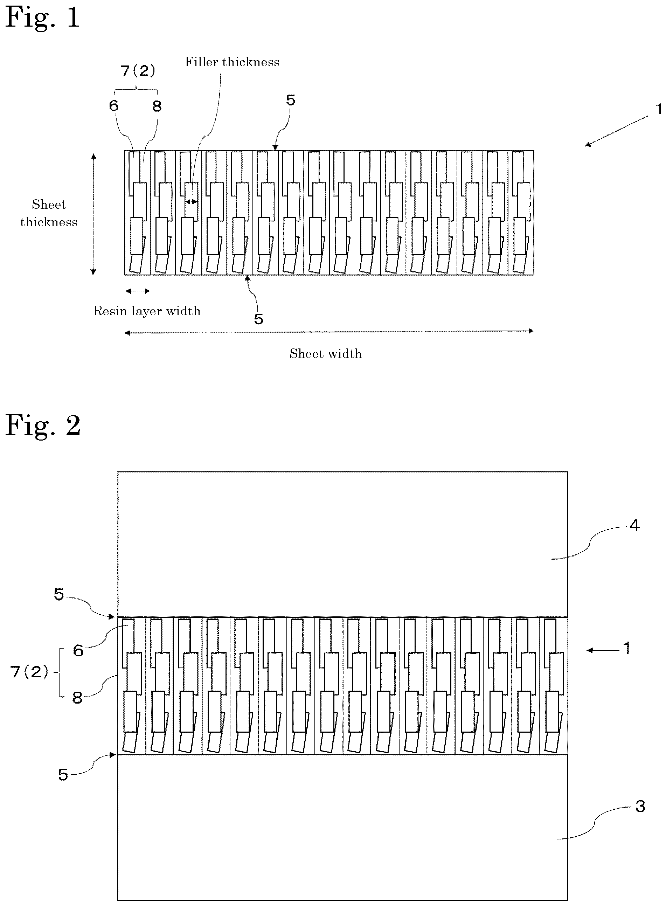

The thermally conductive resin sheet of the present invention may be a single layer or a laminated body. A laminated body in which resin layers comprising a resin and non-spherical fillers are laminated is preferable from a viewpoint of imparting satisfactory heat conductive property. Hereinbelow, an embodiment example of the laminated body in which resin layers comprising a resin and non-spherical fillers are laminated is described in reference to Fig. 1.

In each figure, each of the fillers lies on top of and beneath adjacent fillers, but the fillers do not necessarily have to overlap with each other.

As shown in Fig. 1, a thermally conductive resin sheet 1 has a structure in which a plurality of resin layers 2 are laminated. A vertical plane to the lamination plane of a plurality of resin layers 2 is a sheet surface 5, which is the surface of the resin sheet 1.

The thickness of the thermally conductive resin sheet 1 (that is, the distance between the sheet surface 5 and the sheet surface 5) is not particularly limited and can be, for example, ranged from 0.1 to 30 mm.

The thickness of a single layer of the resin layers 2 (resin layer width) is not particularly limited and is preferably 1000 $\mu$m or less, and more preferably 500 $\mu$m or less, and preferably 0.1 $\mu$m or more, more preferably 0.5 $\mu$m or more, and further preferably 1 $\mu$m or more. The adjustment of thickness as such can enhance the heat conductive property.

The resin layer 2 is a thermally conductive resin layer 7 comprising thermally conductive fillers 6. The thermally conductive resin layer 7 has a structure in which thermally conductive fillers 6 having heat conductive property are dispersed in a resin 8.

In each of the resin layers 2, the thermally conductive fillers are oriented at an angle more than 45° to the sheet surface as described above, and more preferably at an angle of 50° or more, further preferably 60° or more, further preferably 70° or more, and further preferably 80° or more.

A thickness of the thermally conductive resin layer 7 is preferably 1 to 1000 times, and more preferably 1 to 500 times, the thickness of the thermally conductive filler 6 comprised in the thermally conductive resin layer 7.

When a width (thickness) of the thermally conductive resin layer 7 is in the above range, the major axis of the thermally conductive filler 6 is more likely to be oriented at an angle close to 90° to the sheet surface. The width of the thermally conductive resin layer 7 does not have to be uniform as long as it is within the above range.

[Method for producing a thermally conductive resin sheet]

The method for producing the thermally conductive resin sheet of the present invention is not particularly limited, and in the case of producing a single-layer thermally conductive resin sheet, for example, non-spherical thermally conductive fillers, a resin, and additives as needed are fed to an extruder, melt-kneaded to obtain a mixture, and the mixture is extruded into a sheet from the extruder, whereby a thermally conductive resin sheet is formed.

(Method for producing a laminated body)

The method for producing the thermally conductive resin sheet consisting of a laminated body of the present invention is not particularly limited, and as describe below, such a resin sheet can be produced by a method comprising a kneading step, a lamination step, and further a slicing step as needed.

<Kneading step>

Thermally conductive fillers and a resin are kneaded to manufacture a thermally conductive resin composition.

The kneading is preferably carried out by, for example, kneading thermally conductive fillers and a resin using a twin-screw kneader such as a plastomill or a biaxial extruder with heating, and this enables to obtain the thermally conductive resin composition in which the thermally conductive fillers are uniformly dispersed in the resin.

Subsequently, the thermally conductive resin composition is pressed thereby to obtain a sheet-like resin layer (thermally conductive resin layer).

<Lamination step>

In the lamination step, the resin layers obtained in the kneading step are laminated to manufacture a laminated body having an n-layer structure. A method usable as the lamination method is, for example, a method in which the resin layer manufactured in the kneading step is $x_i$ divided and laminated to manufacture a laminated body having an $x_i$-layer structure, then hot-pressed as needed, subsequently the division, the lamination and the hot-pressing are further repeated as needed to manufacture a laminated body having a width of D $\mu$m and an n-layer structure.

When the thermally conductive filler is plate-like, a width of the laminating body (D $\mu$m) after the lamination step and a thickness of the thermally conductive filler (d $\mu$m) preferably satisfy $0.0005 < d/(D/n) \leq 1$, more preferably satisfy $0.001 \leq d/(D/n) \leq 1$, and further preferably satisfy $0.02 \leq d/(D/n) \leq 1$.

Thus, when a plurality of formations are carried out, a forming pressure at each formation can be smaller than the case of a one-time formation, whereby phenomena such as rupture of the laminate structure caused by the formation can be eliminated.

Other lamination methods also usable include, for example, a method in which an extruder equipped with a multilayer forming block is used, and the multilayer forming block is adjusted to obtain a laminated body having the n-layer structure and the width of D $\mu$m by co-extrusion.

Specifically, the thermally conductive resin composition obtained in the kneading step is introduced into both of a first extruder and a second extruder, and the thermally conductive resin compositions are extruded simultaneously from the first extruder and the second extruder. The thermally conductive resin compositions extruded from the first extruder and the second extruder are delivered to a feed block. In the feed block, the thermally conductive resin compositions extruded from the first extruder and the second extruder are merged. As a result, a 2-layer body in which the thermally conductive resin compositions are laminated can be obtained. Subsequently, the 2-layer body is transferred to a multilayer forming block, and the 2-layer body is divided into a plurality of pieces in the direction parallel to the extrusion direction and along with a plurality of planes vertical to the lamination plane and then laminated, whereby a laminated body having an n-layer structure and a width of D $\mu$m can be manufactured. During this process, the thickness per layer (D/n) can be a desired value by adjusting the multilayer forming block.

(Slicing step)

The laminated body obtained in the lamination step is sliced in the direction parallel to the lamination direction thereby to manufacture the thermally conductive resin sheet.

(Other steps)

In the method for producing the thermally conductive resin sheet, a step of crosslinking the resin is preferably provided. Crosslinking is more likely to reduce a rate of change of the 30% compressive strength, a rate of change of the tensile strength, and a rate of change of the Asker C hardness after the heat resistance test of the thermally conductive resin sheet. Crosslinking can be carried out by, for example, a method of irradiating an ionizing radiation such as electron beam, α ray, β ray, or γ ray, or a method that uses an organic peroxide. However, when a gel fraction at the surface layer part of the thermally conductive resin sheet is made higher than a gel fraction at the center part, the sheet surface (sheet surface) is preferably irradiated with an ionizing radiation after the slicing step and, of the ionizing radiations, electron beam is preferable. When the electron beam irradiation is carried out for the purpose of making a gel fraction at the surface layer part higher than a gel fraction at the center part, an accelerating voltage is preferably 50 to 800 kV. An irradiation dose of the electron beam irradiation is preferably 50 to 700 kGy.

Additionally, from a viewpoint of adjusting a gel fraction ratio in the thickness direction of the thermally conductive resin sheet to the desired range as described above, the electron beam irradiation is preferably carried out in a plurality of times respectively to both surfaces of the thermally conductive resin sheet, and the electron beam irradiation is more preferably carried out twice, respectively.

When the electron beam irradiation is carried out twice to the thermally conductive resin sheet, an accelerating voltage of one of the electron beam irradiations (first electron beam irradiation) of the 2 electron beam irradiations is preferably higher than an accelerating voltage of the other electron beam irradiation (second electron beam irradiation), and an irradiation dose of the first electron beam irradiation is preferably lower than an irradiation dose of the second electron beam irradiation. Thus, the adjusted condition of the electron beam irradiation is more likely to adjust a gel fraction ratio in the thickness direction of the thermally conductive resin sheet to the desired range described above. That is, crosslinking occurs to the center part of the sheet during the first electron beam irradiation wherein the electron beam is irradiated at a comparatively high accelerating voltage, whereas a crosslinking degree (gel fraction) at the center part is not increased too high due to a low electron beam irradiation dose. The center part of the sheet is less likely to be crosslinked during the second electron beam irradiation wherein the electron beam is irradiated at a comparatively low accelerating voltage, whereas crosslinking proceeds at the sheet surface and a gel fraction is increased due to a high electron beam irradiation dose.

More specifically, an accelerating voltage during the first electron beam irradiation is preferably 500 to 1000 kV, more preferably 650 to 850 kV, and further preferably 700 to 800 kV. An irradiation dose during the first electron beam irradiation is preferably 50 to 400 kGy, and more preferably 100 to 200 kGy. An accelerating voltage during the second electron beam irradiation is preferably 50 to 450 kV, and more preferably 200 to 400 kV. An irradiation dose during the second electron beam irradiation is preferably 450 to 800 kGy, and more preferably 500 to 700 kGy. The order of the first electron beam irradiation and the second electron beam irradiation is not particularly limited. For example, the second electron beam irradiation may be carried out after the first electron beam irradiation, or the first electron beam irradiation may be carried out after the second electron beam irradiation.

The thermally conductive resin sheet of the present invention has good heat conductive property and flexibility, a low rate of change of the 30% compressive strength after the heat resistance test, and good long-term stability of physical properties. With utilizing these characteristics, the thermally conductive resin sheet of the present invention, for example, when disposed between heating elements and a heat sink in an electronic device, can facilitate the heat dissipation from the heating elements to the heat sink. This is described in reference to the thermally conductive resin sheet 1 illustrated in Fig. 1.

As shown in Fig. 2, in the thermally conductive resin sheet 1, a sheet surface 5 is disposed in such a way as to contact a heating element 3 and a heat sink 4. Further, the thermally conductive resin sheet 1 is disposed between 2 members such as the heating element 3 and the heat sink 4 in a compressed state. The heating element 3 is, for example, a semiconductor package, and the heat sink 4 is, for example, metals such as aluminum and copper. When the thermally conductive resin sheet 1 is used in such a state, the heat generated in the heating element 3 is more likely to be diffused to the heat sink 4 thereby enabling efficient heat radiation.

Examples

The present invention is described in further detail in reference to examples but is not limited at all to these examples.

Materials used in the following examples and comparative examples are as follows.

(1) Resin

- Liquid elastomer 1: liquid polybutadiene rubber, manufactured by KURARAY CO., LTD., product name "L-1203"
- Liquid elastomer 2: liquid polybutadiene rubber, manufactured by Cray Valley, product name "LBH3000"
- Silicone resin: manufactured by Wacker Asahikasei Silicone Co., Ltd., product name "SEMICOSIL 962TC"

(2) Thermally conductive filler

(i) Boron nitride, manufactured by Denka Company Limited., product name "SGP"

Shape; non-spherical (plate-like)
Aspect ratio; 20
Long-side direction heat conductivity; 250 W/m·K
Thickness; 1 μm

(ii) Alumina (aluminum oxide), manufactured by SHOWA DENKO K.K., product name "AS-20"

Shape; spherical
Average particle size; 22 μm

Physical properties and evaluation methods are as follows.

<Viscosity>

Fifty g of a resin was measured at 25°C using a B-type viscometer (manufactured by TOYO-SANGYO. Co. Ltd.).

<Orientation angle>

Cross-section of the thermally conductive resin sheet was observed using a scanning electron microscope (manufactured by Hitachi, Ltd. S-4700). Twenty random fillers from the observed image at 3000x magnification were measured for angles formed between the sheet surface and themselves, and the average value thereof was defined as the orientation angle.

< Heat conductivity>

A heat conductivity in the thickness direction of the obtained thermally conductive resin sheet was measured using a Laser Flash Heat Conductivity Analyzer (manufactured by NETZSCH, "LFA447").

<30% Compressive strength>

A 30% compressive strength of the obtained thermally conductive resin sheet was measured using an A&D Company, Limited "RTG-1250". The measurement was carried out with a sample dimension of 2 mm x 15 mm x 15 mm, at a measurement temperature of 23°C, and a compression rate of 1 mm/min.

<Tensile strength>

A tensile strength of the obtained thermally conductive resin sheet was measured using an A&D Company, Limited "RTG-1250". The measurement was carried out with a sample dimension of 1.5 mm x 10 mm x 60 mm, at a measurement temperature of 23°C and a tensile rate of 500 mm/min.

<Asker C hardness>

Twenty-five mm square thermally conductive resin sheets were laminated in such a way as to have a thickness of 10 mm or more and measured using an ASKER Durometer Type C, (manufactured by KOBUNSHI KEIKI CO., LTD.).

<Rate of change of physical properties after the heat resistance test>

The obtained thermally conductive resin sheet was heated for 1000 hours at 150°C in an oven and measured for a 30% compressive strength, a tensile strength, and an Asker C hardness, respectively to determine rates of changes of physical properties after the heat resistance test by the following formulae.

The rate of change of the 30% compressive strength after the heat resistance test was determined by the following formula (1).

$$| (1 - 30\% \text{ Compressive strength before heat resistance test} / 30\% \text{ compressive strength after heat resistance test}) \times 100 | \quad \text{Formula (1)}$$

The rate of change of the tensile strength after the heat resistance test was determined by the following formula (2).

$$| (1 - \text{Tensile strength before heat resistance test} / \text{tensile strength after heat resistance test}) \times 100 | \quad \text{Formula (2)}$$

The rate of change of the Asker C hardness after heat resistance test was determined by the following formula (3).

$$| (1 - \text{Asker C hardness before heat resistance test} / \text{Asker C hardness after heat resistance test}) \times 100 | \quad \text{Formula (3)}$$

<Gel fraction>

A gel fraction of the thermally conductive resin sheet was measured as described below.

A g of the thermally conductive resin sheet was weighed and immersed in xylene for 24 hours at 120°C, and insoluble matters were filtered through a 200-mesh wire cloth, and the residue on the wire cloth was vacuum dried, and a weight of the dried residue (Bg) was measured, whereby a gel fraction was calculated from a filler weight (Cg) in the thermally conductive resin calculated from a weight of the thermally conductive resin sheet and a filler mixing ratio using the following formula. In each of the examples and comparative examples, the thermally conductive resin sheet was uniformly collected in the thickness direction to measure a gel fraction.

$$\text{Gel fraction (mass\%)} = ((B-C)/A) \times 100$$

<Oil bleed distance>

A sample having a thickness of 2 mm and a size of a 30-mm square was placed at the center on a size A4 paper and measured for distances of oil seeped from edges of the sample 336 hours later at 125°C. The seepage distance is calculated as an average value by measuring the maximum seepage distances from each of the sides of the sample.

<Outgas analysis>

An outgas amount and a silane amount of the obtained thermally conductive resin sheet were measured using a GC/MS system TurboMatrix 350 (manufactured by PerkinElmer Inc). Details of each condition are as follows.

Sample amount: 20 mg
Heating condition: 150°C, 60 min (Carrier gas (He) flow rate: 20 mL/min)
Secondary desorption: 350°C, 40 min
Split: inlet 25 mL/min outlet 25 mL/min
Injection amount 2.5 %
GC/MS System: JMS Q1000 (manufactured by JEOL Ltd.)
Column: EQUITY-1 (non-polar) 0.32 mm x 60 m x 0.2 $\mu$m
GC Temperature Rising: maintained at 40°C for 4 minutes, raised to 300°C at a temperature rising rate of 10°C/min and maintained for 10 minutes.
He flow rate: 1.5 mL/min
Ionization voltage: 70 eV
MS Measurement range: 29 to 600 amu (scan 500 ms)
MS Temperature: ion source; 230°C, interface; 250°C

<Surface tensile strength measurement>

A surface tensile strength of the thermally conductive resin sheet was measured by the following (1) to (3).

(1) A polycarbonate plate 11 having a thickness of 10 mm and a size of 50 mm x 50 mm, a thermally conductive resin sheet 12 having a thickness of 2 mm and a size of 25 mm x 25 mm, and a T-shaped aluminum jig (A5052) 13 consisting of a flat plate part 13a (size 25 mm x 25 mm) and a stick-like member 13b (length 25 mm) fixed vertically from the center part of the flat plate part 13a are prepared.
(2) As shown in Fig. 3, the thermally conductive resin sheet 12 is interposed between the polycarbonate plate 11 and the flat plate part 13a of the T-shaped aluminum jig 13, and a load is applied to 30% compress the thickness of the thermally conductive resin sheet 12 and thereby to adhere the sheet thereto. The thickness of the thermally conductive resin sheet 12 at the compression is 1.4 mm.
(3) The sheet is cured for 24 hours at 23°C in the state of the above (2) followed by releasing the load, and after the lapse of 60 minutes, the polycarbonate plate is fixed onto a tensile tester (manufactured by A&D Company, Limited, TENSILON RTG-1310) and, as shown in Fig. 4, the T-shaped aluminum jig 13 is pulled upward in a rate of 1.0 mm/min, during which the relation between a strain (a length elongated in the thickness direction: mm) and a stress (N/mm$^2$) of the thermally conductive resin sheet is measured.

The measurement was carried out under the conditions of a distance between chucks of 0.17 mm and a gauge length of 0.17 mm.
In the present measurement, the maximum value of stress is defined as the "surface tensile strength" and the strain at the time of a stress of 0.01 N/mm$^2$ is defined as the "elongation".

<Appearance>

In the surface tensile strength measurement described above, an appearance of the thermally conductive resin sheet after the load was released was visually observed and evaluated by the following criteria.

A··Adhesiveness to the polycarbonate plate was satisfactory and cells and cracks were not confirmed.
B··Adhesiveness to the polycarbonate plate was poor, or even when adhesiveness was satisfactory, either cells or cracks were confirmed.
C··Thickness of the thermally conductive resin sheet 12 after load was released changed from 1.4 mm by 0.1 mm or more.
D··Both B and C phenomena were identified.

<Attachment test>

Attachment test was carried out by which each of the obtained thermally conductive resin sheets before and after the heat resistance test was attached on a test substrate, on which a BGA (Ball Grid Array) was mounted, in such a way as to be 30% compressed, and the presence or absence of faults such as solder cracks and short circuits after attachment was observed using an electrical resistance value or an X-ray apparatus. Evaluations were made by the following evaluation criteria.

A: No fault
B: Faults are present, less than 1% of faults or less than 1% of electrical resistance value change
C: 1% or more of faults or 1% or more of electrical resistance value change

<Reworkability evaluation>

The thermally conductive resin sheet having a dimension of 1.5 mm x 20 mm x 100 mm was affixed onto a film (PET material) at 40°C. Thereafter, a peeling test was carried out under the conditions at 23°C, a peeling angle of 90°, and a peeling rate of 30 mm/min.

A: Thermally conductive resin sheet was smoothly peeled
B: Thermally conductive resin sheet was torn (ruptured) while peeling

<Stain test>

The obtained thermally conductive resin sheet was attached on a test substrate, on which a BGA was mounted, in such a way as to be 30% compressed, and the staining property 1000 hours later at 125°C was visually evaluated using the following evaluation criteria.

A: No stain
B: Stained only around the BGA
C: Stained around the BGA and on the substrate

<Cloud test>

A sample bottle, in which a 30 mm-square of the obtained thermally conductive resin sheet was placed, was covered with a glass plate, a cooling plate was put thereon, and the sample bottle was heated on a hot plate at 150°C. The heated glass plate was visually evaluated 24 hours later using the following evaluation criteria.

A: No cloudiness
B: Cloud confirmable with a light
C: Cloud visually confirmable

<Dielectric characteristics>

The thermally conductive resin sheet was cut to a size of 15 mm x 15 mm and laminated in such a way as to be about 400 $\mu$m thereby to obtain a laminated body. A dielectric constant and a dielectric tangent of the laminated body at 23°C at a frequency of 1 MHz were measured using HP4291B (manufactured by HEWLETT PACKARD).

(Example 1)

A mixture consisting of 100 parts by mass of a liquid elastomer 1 (manufactured by KURARAY CO., LTD., product name "L-1203") and 330 parts by mass of boron nitride (manufactured by Denka Company Limited., product name "SGP") was melt-kneaded and then pressed to obtain a sheet-like resin layer having a thickness of 0.5 mm, a width of 80 mm and a depth of 80 mm. For the subsequent lamination step, the obtained resin layer was cut into 16 even pieces and superimposed to obtain a laminated body consisting of 16 layers and having a total thickness of 8 mm, a width of 20 mm and a depth of 20 mm. Then, the laminated body was sliced parallel to the lamination direction thereby to obtain a thermally conductive resin sheet having a thickness of 2 mm, a width of 8 mm and a depth of 20 mm. A single layer of the resin layers composing the laminated body of the thermally conductive resin sheet had a thickness of 0.5 mm. Then, both surfaces of the thermally conductive resin sheet were irradiated with an electron beam having an accelerating voltage of 750 kV and a dose of 150 kGy and then further irradiated with an electron beam having an accelerating voltage of 300 kV and a dose of 600 kGy thereby to crosslink the sheet. This thermally conductive resin sheet was evaluated for each of the items shown in Table 1.

(Example 2)

A thermally conductive resin sheet was obtained in the same manner as in Example 1, except that the kind and the amount of the resin and the thermally conductive filler were changed as shown in Table 1. This thermally conductive resin sheet was evaluated for each of the items shown in Table 1.

(Comparative Example 1)

A mixture consisting of 100 parts by mass of a two-part curable silicone resin (manufactured by Wacker Asahikasei Silicone Co., Ltd., product name "SEMICOSIL 962TC", mixing ration is material A : material B = 1:1) and 330 parts by mass of boron nitride (manufactured by Denka Company Limited., product name "SGP") was melt-kneaded and then pressed to obtain a sheet-like resin layer having a thickness of 0.5 mm, a width of 80 mm and a depth of 80 mm. For the subsequent lamination step, the obtained resin layer was cut into 16 even pieces and superimposed to obtain a laminated body consisting of 16 layers and having a total thickness of 8 mm, a width of 20 mm and a depth of 20 mm. Then, the laminated body was sliced parallel to the lamination direction thereby to obtain a thermally conductive resin sheet having a thickness of 2 mm, a width of 8 mm and a depth of 20 mm. A single layer of the resin layers composing the laminated body of the thermally conductive resin sheet had a thickness of 0.5 mm. Then, the thermally conductive resin sheet was heated for 5 minutes at 100°C and crosslinked. This thermally conductive resin sheet was evaluated for each of the items shown in Table 1.

(Comparative Examples 2 to 3)

Thermally conductive resin sheets were obtained in the same manner as in Comparative Example 1, except that the kind and the amount of the resin and the thermally conductive filler were changed as shown in Table 1. These thermally conductive resin sheets were evaluated for each of the items shown in Table 1.

[Table 1]

|  |  |  | Example | | Comparative Example | | |
|---|---|---|---|---|---|---|---|
|  |  |  | 1 | 2 | 1 | 2 | 3 |
| Composition | Resin [part by mass] | Liquid elastomer 1 (L-1203) | 100 |  |  |  |  |
|  |  | Liquid elastomer 2 (Krasol LBH3000) |  | 100 |  |  |  |
|  |  | Silicone resin |  |  | 100 | 100 | 100 |
|  | Thermally conductive filler [pats by mass] | Boron nitride | 330 | 400 | 330 | 400 |  |
|  |  | Alumina |  |  |  |  | 1500 |
| Viscosity of resin [Pa·s] | | | 35 | 65 | 150 | 150 | 130 |
| Electron beam crosslinking conditions | | | 750kV-150kGy 300kV-600kGy | 750kV-150kGy 300kV-600kGy |  |  |  |

(continued)

| | | Example | | Comparative Example | | |
|---|---|---|---|---|---|---|
| | | 1 | 2 | 1 | 2 | 3 |
| Performance | Orientation angle of thermally conductive filler [°] | 85 | 80 | 83 | 82 | - |
| | Heat conductivity [W/m·K] | 10.5 | 10.9 | 9.5 | 9.3 | 7.1 |
| | 30% Compressive strength [kPa] | 750 | 1420 | 950 | 1340 | 1470 |
| | Tensile strength [MPa] | 0.71 | 0.44 | 0.22 | 0.16 | 0.21 |
| | Asker C hardness | 41 | 51 | 40 | 47 | 50 |
| | 30% Compressive strength after heat resistance test [kPa] | 870 | 1490 | 1790 | 2230 | 2210 |
| | Tensile strength after heat resistance test [MPa] | 0.57 | 0.37 | 0.13 | 0.09 | 0.11 |
| | Asker C hardness after heat resistance test | 45 | 55 | 60 | 72 | 73 |
| | Rate of change of 30% compressive strength [%] | 14 | 5 | 47 | 40 | 33 |
| | Rate of change of tensile strength [%] | 25 | 19 | 69 | 78 | 91 |
| | Rate of change of Asker C hardness [%] | 9 | 7 | 33 | 35 | 32 |
| | Oil bleed distance [mm] | 5 | 7 | 16 | 13 | 12 |
| | Gel fraction (Overall) [%] | 28 | 16 | 15 | 16 | 16 |
| | Gel fraction at surface layer part [%] (*1) | 34 | 28 | 15 | 17 | 16 |
| | Gel fraction at center part [%] | 24 | 5 | 16 | 15 | 15 |
| | Gel fraction ratio in thickness direction | 0.71 | 0.18 | 1.07 | 0.88 | 0.94 |
| | Outgas amount [ppm] | 285 | 241 | 830 | 537 | 109 |
| | Siloxane amount [ppm] | 0 | 0 | 230 | 131 | 22 |
| | Surface tensile strength [N/mm$^2$] | 0.16 | 0.11 | 0.09 | 0.07 | 0.13 |
| | Elongation [mm] | 0.55 | 0.24 | 0.23 | 0.19 | 0.18 |
| | Appearance after adhered | A | A | A | A | A |
| Evaluation | Attachment test (before heat resistance test / after heat resistance test) | A/A | A/A | A/B | A/C | A/C |
| | Reworkability (before heat resistance test / after heat resistance test) | A/A | A/A | A/B | A/B | A/B |
| | Staining property | A | A | C | C | B |
| | Cloud test | A | A | C | C | C |
| | Dielectric constant @1MHz | 4.2 | 3.8 | 4.6 | 4.4 | 6.7 |
| | Dielectric tangent @1MHz | 0.004 | 0.002 | 0.005 | 0.004 | 0.09 |

(*1) Gel fraction at the surface layer part indicates gel fractions on both surface layers of the sheet. The gel fractions on both surface layers had the identical values.

The thermally conductive resin sheets of the present invention shown in Examples 1 and 2 had high heat conductivity, flexibility and satisfactory results on the attachment test with long-term stability of physical properties without becoming hardened over time.

Additionally, the thermally conductive resin sheets of the present invention had high heat conductivity and flexibility, low outgas amounts and siloxane amounts, with satisfactory results on the cloud test. In addition, these thermally conductive resin sheets had short oil bleed distances and satisfactory results on the cloud test, with good balance of physical properties. To the contrary, it was revealed that the thermally conductive resin sheets shown in Comparative Examples 1 to 3 were difficult to maintain satisfactory long-term physical properties, further had large outgas amounts and siloxane amounts and poor results on the cloud test, and the outgas generation that was not reduced.

Reference Signs List

1     Thermally conductive resin sheet
2     Resin layer
3     Heating element
4     Heat sink
5     Sheet surface
6     Thermally conductive filler
7     Thermally conductive resin layer
8     Resin
11    Polycarbonate plate
12    Thermally conductive resin sheet
13    T-shaped aluminum jig
13a   Flat plate part
13b   Stick-like member

**Claims**

1. A thermally conductive resin sheet having a heat conductivity of 7 W/m·K or more, a 30% compressive strength of 1500 kPa or less, and a rate of change of the 30% compressive strength of 30% or less after a heat resistance test in which the thermally conductive resin sheet is heated for 1000 hours at 150°C.

2. A thermally conductive resin sheet having a heat conductivity of 7 W/m·K or more, a 30% compressive strength of 1500 kPa or less, a total amount of an outgas of 500 ppm or less, and a total siloxane amount of 20 ppm or less contained in the outgas.

3. The thermally conductive resin sheet according to claim 1 or 2, wherein a tensile strength is 0.08 MPa or more, and a rate of change of the tensile strength after the heat resistance test is 0 to 30%.

4. The thermally conductive resin sheet according to any of claims 1 to 3, wherein a surface tensile strength when the thermally conductive resin sheet is 30% compressed, cured for 24 hours at 23°C in the compressed state and subsequently measured for the surface tensile strength is 0.10 N/mm$^2$ or more, or an elongation at the surface tensile strength measurement is 0.20 mm or more.

5. The thermally conductive resin sheet according to any of claims 1 to 4, comprising an elastomer resin.

6. The thermally conductive resin sheet according to claim 5, wherein the elastomer resin comprises a liquid elastomer resin.

7. The thermally conductive resin sheet according to claim 6, wherein a viscosity of the liquid elastomer resin at 25°C is 1 to 150 Pa·s.

8. The thermally conductive resin sheet according to any of claims 1 to 7, comprising a thermally conductive filler.

9. The thermally conductive resin sheet according to claim 8, wherein the thermally conductive filler comprises a non-spherical filler.

10. The thermally conductive resin sheet according to claim 8 or 9, wherein a major axis of the thermally conductive filler is oriented at an angle of 60° or more to a sheet surface.

**11.** The thermally conductive resin sheet according to any of claims 1 to 10, which is crosslinked.

**12.** The thermally conductive resin sheet according to any of claims 1 to 11, wherein an oil bleed distance is 10 mm or less.

**13.** The thermally conductive resin sheet according to any of claims 1 to 12, wherein a gel fraction at at least one of surface layer parts is higher than a gel fraction at a center part.

# Fig. 1

# Fig. 2

Fig. 3

Fig. 4

## INTERNATIONAL SEARCH REPORT

| | International application No. |
|---|---|
| | PCT/JP2020/001992 |

**A. CLASSIFICATION OF SUBJECT MATTER**
H01L 23/36(2006.01)i; C08L 21/00(2006.01)i; C08J 5/18(2006.01)i; C08K 3/38(2006.01)i; C08J 7/00(2006.01)i
FI: C08J5/18 CEQ; C08L21/00; C08K3/38; C08J7/00 305; H01L23/36 D
According to International Patent Classification (IPC) or to both national classification and IPC

**B. FIELDS SEARCHED**

Minimum documentation searched (classification system followed by classification symbols)
C08J5/18; C08J7/00; H01L23/36; C08L; C08K

| Documentation searched other than minimum documentation to the extent that such documents are included in the fields searched | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2018/101445 A1 (SEKISUI CHEMICAL CO., LTD.) 07.06.2018 (2018-06-07) claims paragraphs [0010], [0015], [0023], [0026]–[0028], [0030]–[0034], examples, table 1, drawings | 1–13 |
| X<br>A | JP 2010-132866 A (HITACHI CHEMICAL INDUSTRY CO., LTD.) 17.06.2010 (2010-06-17) claims, paragraphs [0007], [0008], [0029], [0032], [0034], [0042], examples | 1–12<br>13 |
| X<br>A | JP 2011-162642 A (HITACHI CHEMICAL INDUSTRY CO., LTD.) 25.08.2011 (2011-08-25) claims, paragraphs [0005], [0007], [0029], [0031], [0041], examples | 1–12<br>13 |
| A | WO 2018/030430 A1 (SEKISUI CHEMICAL CO., LTD.) 15.02.2018 (2018-02-15) entire text | 1–13 |
| A | JP 2013-103375 A (DAICEL CORPORATION) 30.05.2013 (2013-05-30) entire text | 1–13 |

☒ Further documents are listed in the continuation of Box C.    ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 03 April 2020 (03.04.2020) | 14 April 2020 (14.04.2020) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.

PCT/JP2020/001992

C (Continuation). DOCUMENTS CONSIDERED TO BE RELEVANT

| Category* | Citation of document, with indication, where appropriate, of the relevant passages | Relevant to claim No. |
|---|---|---|
| A | JP 2010-77220 A (FURUKAWA ELECTRIC CO., LTD.) 08.04.2010 (2010-04-08) entire text | 1-13 |
| P, A | WO 2019/022070 A (SEKISUI CHEMICAL CO., LTD.) 31.01.2019 (2019-01-31) entire text | 1-13 |

Form PCT/ISA/210 (continuation of second sheet) (January 2015)

**INTERNATIONAL SEARCH REPORT**
Information on patent family members

International application No.

PCT/JP2020/001992

| Patent Documents referred in the Report | Publication Date | Patent Family | Publication Date |
|---|---|---|---|
| WO 2018/101445 A1 | 07 Jun. 2018 | US 2019/0241786 A1 claims, examples, table 1, drawings EP 3549974 A1 CN 109843991 A KR 10-2019-0087431 A | |
| JP 2010-132866 A | 17 Jun. 2010 | (Family: none) | |
| JP 2011-162642 A | 25 Aug. 2011 | (Family: none) | |
| WO 2018/030430 A1 | 15 Feb. 2018 | US 2019/0176448 A1 EP 3499561 A1 KR 10-2019-0039943 A CN 109729739 A | |
| JP 2013-103375 A | 30 May 2013 | (Family: none) | |
| JP 2010-77220 A | 08 Apr. 2010 | (Family: none) | |
| WO 2019/022070 A1 | 31 Jan. 2019 | JP 2019-24045 A TW 201908460 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012038763 A
- JP 2013254880 A